# EUROPEAN PATENT APPLICATION

(11) **EP 4 390 430 A1**
(43) Date of publication of application: **26.06.2024**
(21) Application number: 22215566.5
(22) Date of filing: 21.12.2022
(51) Int. Cl.: G01R 33/38, G01R 33/24, G01R 33/42, G01R 33/44, G01R 33/02, G01R 33/10, G01R 33/28, G01R 33/381, G01R 33/028

(54) **METHOD AND SYSTEM FOR DETERMINING A POSITION OF A PORTABLE MRI SYSTEM**

(71) Applicant: Koninklijke Philips N.V., 5656 AG Eindhoven (NL)
(72) Inventor: WEISS, Steffen, Eindhoven (NL); LEUSSLER, Christoph Günther, Eindhoven (NL); VOGTMEIER, Gereon, 5656AG Eindhoven (NL); JOHNSON, Mark Thomas, Eindhoven (NL)
(74) Representative: Philips Intellectual Property & Standards

(57) **Abstract**

Influence of RF noise and external magnetic field on the image quality of a portable magnetic resonance imaging (MRI) system (1) are to be avoided. This is achieved by providing a system and a computer-implemented method for determining an optimized position and/or orientation of a portable MRI system (1) for an MR imaging process in a medical environment (2), comprising at least one RF noise sensor (3), wherein the RF noise sensor (3) is configured for measuring RF noise in the medical environment (2) and to provide sensor data, at least one magnetic field sensor (4), wherein the magnetic field sensor (4) is configured to measure the external magnetic field in the medical environment (2) and to provide sensor data, a processor unit (5), wherein the sensors (3, 4) are connected to the processor unit (5), the processor unit (5) comprising at least one memory (6) for storing instructions, at least one processor (7) configured to execute the instructions to cause the following to be performed: measuring RF noise and the external magnetic field in the medical environment by means of corresponding sensors (3, 4), evaluating the sensor data and creating spatial distributions of the measured RF noise and/or the measured external magnetic field in the medical environment (2), determining a position and/or orientation of the portable MRI system (1) in the medical environment (2) for an MR imaging process based on the spatial distributions of the measured RF noise and/or the measured external magnetic field.

## Description

### FIELD OF THE INVENTION

The invention relates to the field of portable magnetic resonance imaging (MRI) systems, and in particular to a system and a computer-implemented method for determining a position and/or orientation of a portable MRI system for an MR imaging process in a medical environment to minimize the influence of RF noise and external magnetic field on the image quality of the portable MRI system.

### BACKGROUND OF THE INVENTION

Magnetic resonance imaging (MRI) is an essential diagnostic tool in today's healthcare. Until recently, a patient needing an MRI would need to be transported to the radiology department and carefully positioned in a large magnet. For many patients in critical condition, traditional MRI is difficult. For this reason, portable magnetic resonance imaging (MRI) systems have been developed to improve and make rapid clinical diagnoses designed to be used in critical or emergency care settings on patients who would otherwise be unable to receive a timely MR head scan. Portable MRI systems are low-field MR systems (B₀ < 200mT) that are designed to be easily movable by staff within a hospital with the purpose to use them at the point of care, for example at the bed of the patient. Such systems aim to provide more accessible MR imaging at affordable prices worldwide, because they are cheaper themselves and do not require a large and fixed hospital installation including an RF-shielded room and a technical room. Portable MRI systems can be wheeled around in the hospital by staff, plugged into normal mains power and used at the point-of-care for example at the bed of the patient. They are also marketed for use in emergency departments, intensive care unit, and operating rooms. Operated without any RF-shielded room and in different magnetic environments, image quality is impaired by RF noise and external magnetic field, which vary considerably on short distances.

Radiofrequency (RF) coils are an essential MRI hardware component. RF coils are the antennas of the MRI system and have two functions: first, to excite the magnetization by broadcasting the RF power (Tx-Coil) and second to receive the signal from the patient (Rx-Coil) that is used to reconstruct MR images. This signal is typically orders of magnitudes lower than RF noise emitted by electrical equipment of all kinds. To provide good image quality standard MR systems within a fixed hospital installation are in an RF-screened room which is a Faraday cage that prevents any RF noise to enter the room. Therefore, the room is equipped with walls including a copper layer, special semi-transparent windows equipped with fine copper mesh, and doors equipped with copper lamella that are RF-tight when closed. Such a shielding solution is technically optimal but very costly and requires a lot of space. In difference to this portable MRI systems are operated in normal hospital rooms and are subject to the intense RF noise produced by various pieces of equipment in the hospital or external RF radiation sources, e.g., radio stations. If no counter measures are taken this RF noise is devastating for the image quality in portable MRI systems.

MR systems in fixed hospital installations are typically also protected from magnetic field disturbances by two effects: firstly, they are equipped with superconducting coils and a self-shielding mechanism which both lower the influence of external magnetic field in the imaging field-of-view. Secondly, during siting of the MR system care is taken that regions with strong magnetic field perturbations (elevators, high power electrical equipment and cabling) are avoided. In difference to portable MRI systems are subject to external magnetic field perturbations which greatly impair image quality.

It is important to note that both, RF noise and magnetic field perturbations vary considerably with location in any hospital setting. For RF noise this is in particular due to hospital equipment emitting RF noise. If a portable MRI system is operated next to such an emitter image noise will be very strong and imaging may become impossible. If the portable MRI system is moved away a few meters from such an emitter then RF noise will be greatly reduced, so that standard noise suppression techniques and the partial RF screen provided by the portable MR system can be effective enough to enable MR imaging. The same local character applies to magnetic field. High power electrical equipment such as elevators, electrical motors of other heavy equipment as electric vehicles and their power cables generate magnetic field that impair image quality of a portable MR system. However, also these magnetic field are very local and drop off quickly with distance.

### SUMMARY OF THE INVENTION

It is an object of the invention to provide a system and a method for determining an optimized position and/or orientation of a portable magnetic resonance imaging (MRI) system for an MR imaging process in a medical environment influenced by RF noise and/or external magnetic field.

According to the invention, this object is addressed by the subject matter of the independent claims. Further embodiments of the invention are described in the dependent claims.

According to a first aspect of the invention, a system for determining an optimized position and/or orientation of a portable magnetic resonance imaging (MRI) system for an MR imaging process in a medical environment influenced by RF noise and/or external magnetic field. Determining such an optimized position and/or orientation of the portable MRI system means, in the context of the presently claimed invention, determining the best, or as good as possible position and/or orientation for the MR imaging process to be conducted with the least effect or influence from the RF noise and/or external magnetic field present in the medical environment where the MRI system is located. When the MR imaging process is conducted with such optimized position and/or orientation, the image quality is enhanced. The system comprises: at least one RF noise sensor, wherein the RF noise sensor is configured for measuring RF noise in the medical environment and to provide sensor data; at least one magnetic field sensor, wherein the magnetic field sensor is configured to measure the external magnetic field in the medical environment and to provide sensor data; a processor unit, wherein the sensors are connected to the processor unit, the processor unit comprising: at least one memory for storing instructions, at least one processor configured to execute the instructions to cause the following to be performed: measuring RF noise and/or the external magnetic field in the medical environment by means of corresponding sensors; evaluating the sensor data and creating spatial distributions of the measured RF noise and/or the measured external magnetic field in the medical environment, determining a position and/or orientation of the portable MRI system in the medical environment for an MR imaging process based on the spatial distributions of the measured RF noise and/or the measured external magnetic field. The term external magnetic field refers to any magnetic field that is not generated by coils of the portable MRI system. In particular, various electrical devices as devices with wireless communication, computer hardware, and small electrical motors may be responsible for emitting RF noise, and devices as elevators, electrically driven carts, hospital beds and any high power electrical motors may be responsible for emitting external magnetic field.

In a technically advantageous embodiment of the system the at least one RF noise sensor and/or the at least one magnetic field sensor are distributed in the medical environment. This has the advantage that, for example, the sensors can be installed at critical locations where RF noise and/or external magnetic fields can be expected, which can monitor this area of the medical environment.

In another technically advantageous embodiment of the system the at least one RF noise sensor and/or the at least one magnetic field sensor are portable sensor devices, wherein the portable sensor devices are connected to the portable MRI system wirelessly or by cable. This has the advantage that, for example, a large area of the medical environment can be measured by moving the portable sensors.

In another technically advantageous embodiment of the system the at least one RF noise sensor and/or the at least one magnetic field sensor are handheld or wearable sensor devices which are suitable to be carried by staff and/or suitable to be carried by autonomously self-driving vehicles. The handheld or wearable sensor devices can identify operation locations which are historically identified as being unsuitable and should probably be avoided if possible. The devices can be carried by staff, or by autonomously self-driving vehicles for example to patrol the building e.g., at night-time for the purpose of mapping. They may also assist to precisely identify noise sources in the vicinity of the portable MRI system.

In a technically advantageous embodiment of the system an MR-RF coil of the portable MRI system is configured to be used as RF noise sensor to measure RF noise. The MR-RF coil of an MRI system is a very sensitive receive antenna. Therefore, in an embodiment of the invention it is proposed to use the MR-RF coil to detect RF noise e.g., during transport of the system. This has the advantage that it detects any RF noise with the same spatial- and frequency-dependent receive characteristics that is also relevant for MR imaging. Moreover, this dual use of the MR hardware saves weight, volume, and cost.

In another technically advantageous embodiment of the system the at least one of the at least one RF noise sensors is a directional RF antenna for RF noise measurements. Directional RF antennas may be used to determine the location of strong RF emitters.

In a technically advantageous embodiment of the system the system is configured such that the directional RF antenna is read out by the MR receive chain of the portable MRI system. In this way, the readout of the directional RF antenna can already be ensured by existing hardware.

In another technically advantageous embodiment of the system a Bo-coil of the portable MRI system is configured to be used as magnetic field sensor to measure the external magnetic field which has the advantage to save space, weight, and cost for a dedicated sensor for such fields.

In a technically advantageous embodiment of the system, the system comprises at least one sensor for measuring motion and/or position of the portable MRI system, for example, based on any of the known methods for measuring motion (GPS, triangulation, IMUs etc.). This has the advantage that RF noise and magnetic fields can be associated with the current location of the system and therefore be mapped in space. Moreover, it has the advantage that allows deriving the velocity of the system which may be used when using the Bo-coil as sensor for external magnetic fields.

In another technically advantageous embodiment of the system, the system comprises a mapping unit, wherein the mapping unit is configured to create an interference map with known and estimated interference strength based on the measured RF noise and external magnetic field. By providing an interference map through the mapping unit, information is available to assist in determining an optimized position for imaging.

In a technically advantageous embodiment of the system, the system comprises an MR artefact prediction unit, wherein the MR artefact prediction unit is configured to estimate a level of image artefacts in an MR imaging process that will be caused by the estimated interferences. This also has the advantage of assisting in determining an optimized position for imaging.

In a second aspect of the invention, the object is achieved by a computer-implemented method for determining an optimized position and/or orientation of a portable magnetic resonance imaging (MRI) system for an MR imaging process in a medical environment influenced by RF noise and/or external magnetic field, the method comprising the following steps: measuring RF noise in the medical environment by at least one RF noise sensor and providing sensor data and/or measuring the external magnetic field in the medical environment by at least one magnetic field sensor and providing sensor data; evaluating the sensor data and creating a spatial distribution of the measured RF noise and the measured external magnetic field; determining a position and/or orientation of the portable MRI system for an MR imaging process based on the spatial distribution of the measured RF noise and/or measured external magnetic field.

In a technically advantageous embodiment of the method, the step of measuring RF noise and external magnetic field by means of corresponding sensors in the medical environment comprises the step of measuring RF noise and/or external magnetic field by sensors distributed in the medical environment, and/or measuring RF noise by an MR-RF coil of the portable MRI system, and/or measuring RF noise by a directional RF antenna, and/or measuring external magnetic field by a Bo-coil of the portable MRI system.

In another technically advantageous embodiment, the method comprises the following additional step: creating an interference map with known and estimated interference strength based on the measured RF noise and external magnetic field. By providing an interference map through the mapping unit, information is available to help determine an optimal position of the portable MRI system for imaging.

In a technically advantageous embodiment, the method comprises the following additional step: estimating a level of image artefacts in an MR imaging process caused by the estimated and known interferences. This also has the advantage of assisting in determining an optimized position of the portable MRI system for imaging.

In a technically advantageous embodiment of the method, the method comprises the following additional step: providing live guidance based on the sensor data to a portable MRI system operator to position and/or orient the portable MRI system. By providing live guidance, locations with high interference, i.e., locations highly influenced by RF noise and/or external magnetic field can be avoided, and as a consequence, image quality can be improved.

As such, executing the method enables the user to have the benefits of the system from the first aspect of the invention.

According to a third aspect of the invention, there is provided a computer program element which, when being executed by at least one processing unit, is adapted to cause the processing unit to perform the steps of the method according to the second aspect of the invention.

According to a fourth aspect of the invention, there is provided a computer readable medium having stored the program element.

These and other aspects of the present invention will become apparent from and elucidated with reference to the embodiments described hereinafter.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a medical environment with a portable MRI system and a system for determining a position and/or orientation of the portable MRI system according to an embodiment of the invention,
Fig. 2 schematically depicts an RF signal path of a portable MRI system according to another embodiment of the invention,
Fig. 3 depicts a flowchart of a computer-implemented method for determining a position and/or orientation of a portable MRI system in a medical environment according to an embodiment of the invention.

### DETAILED DESCRIPTION OF EMBODIMENTS

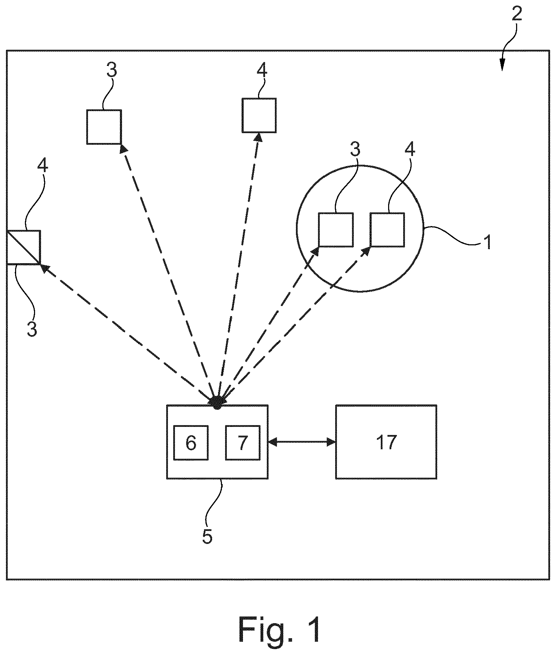

Fig. 1 schematically depicts a medical environment 2 with a portable magnetic resonance imaging (MRI) system 1 and a system for determining an optimized position and/or orientation of the portable MRI system 1 according to an embodiment of the invention. The MRI system 1, suitable to perform an MR imaging process, is located in the medical environment 2. The portable MRI system 1 can be moved freely within the clinical environment 2. This exposes it to RF noise and magnetic fields. Hence, according to an embodiment of the invention, there is a system for determining an optimized position and/or orientation of the portable MRI system 1 for an MR imaging process in a medical environment 2 influenced by RF noise and/or external magnetic fields. In the context of the presently claimed invention, determining an optimized position and/or orientation of the portable MRI system 1 means, in the context of the present invention, determining the best, or as good as possible position and/or orientation of a portable MRI system 1 for an MR imaging process to be conducted with the least effect or influence from the RF noise and/or external magnetic field present in the medical environment 2 where the MRI system 1 is located. When the MR imaging process is conducted with the least effect/influence from the referred disturbances, or similarly, when the portable MRI system avoids locations with high interference, the quality of the imaging will be improved.

The system for determining an optimized position and/or orientation of a portable MRI system 1 comprises at least one RF noise sensor 3, wherein the RF noise sensor 3 is configured for measuring RF noise in the medical environment 2 and to provide sensor data. The system further comprises at least one magnetic field sensor 4, wherein the magnetic field sensor 4 is configured to measure the external magnetic field in the medical environment 2 and to provide sensor data. The system further comprises a processor unit 5, wherein the sensors 3, 4 are connected to the processor unit 5. The processor unit 5 comprises at least one memory 6 for storing instructions and at least one processor 7 configured to execute the instructions. Based on the instructions executed by the processor 7 the following is performed: measuring RF noise and/or the external magnetic field in the medical environment 2 by means of corresponding sensors 3, 4, evaluating the sensor data and creating spatial distributions of the measured RF noise and/or the measured external magnetic field in the medical environment 2, determining a position and/or orientation of the portable MRI system 1 in the medical environment 2 for an MR imaging process based on the spatial distributions of the measured RF noise and/or the measured external magnetic field.

The at least one RF noise sensors 3 and/or the at least one magnetic field sensor 4 may be distributed in the medical environment 2, for example, at critical locations where RF noise and/or external magnetic fields can be expected.

Portable MRI systems 1 are operated at low magnetic field B₀ (typically below 0.3T) and are equipped with a normal electromagnetic Bo coil to generate this field only if they are actually imaging. In an embodiment of the invention the Bo coil of the portable MRI system 1 is configured to be used as magnetic field sensor 4. This is done by measuring the voltage that is induced in the Bo coil due to either the motion of the system 1 in the external magnetic field gradient or due to the time-variation of the external magnetic field itself. It is not a major drawback, that this system is insensitive to time-constant external field as soon as it is parked, because time-constant external field typically do not cause major image artefacts as they are usually compensated by shimming at the beginning of each MR scan. The B₀ coil similarly as the MR-RF coil has exactly the spatial- and frequency-dependent magnetic field sensing characteristics that is also relevant for MR imaging.

In an embodiment of the invention, the MR Bo coils and magnetic field sensors at the portable MRI system 1, and also additional external sensors 3, 4 at fixed locations in the hospital are used to measure external magnetic field. In order to assess the magnitude of the magnetic field, the velocity vector of the system motion is used, because any induced voltage in the B₀ coil depends linearly on this velocity. Therefore, in an embodiment of the invention the system comprises at least one sensor for measuring motion and/or position of the portable MRI system. The velocity is determined based on any of the known methods for measuring motion (GPS, triangulation, IMUs etc.); the velocity may be obtained from the data out of the at least one sensor for measuring motion and/or position. This has the advantage that RF noise and magnetic fields can be associated with the current location of the system and therefore be mapped in space. Further, the velocity of the system is required when using the Bo-coil as sensor for external magnetic fields, because static external fields can only be sensed via induction due to motion of the system. As mentioned, in order to assess the magnitude of the external magnetic field, the velocity vector of the system motion is used because any induced voltage in the B₀ coil depends linearly on this velocity.

Additionally, dedicated RF coils may be fixedly installed at locations of the hospital where the portable MRI system 1 is e.g., frequently used or at or near devices that are known to emit RF noise temporarily but not easily foreseeable, as RF-based communication devices. These external noise receivers may transmit their measurement results wirelessly to the portable MRI system 1, or to a central server to which the portable MRI system is also live connected. For the evaluation of sensor data, the system includes a processor unit 5 with a processor 6 and a memory 7 for executing commands.

In a further embodiment of the invention the system comprises a mapping unit. For example, RF noise and external magnetic field at the current location of the main system 1 and at locations of external receivers, or previously mapped data of that kind are used as input data. Potentially, layout data of the building can be used as input data for producing a map of the medical environment. The output is an "interference map" with known and estimated interference strength based on the measured RF noise and external magnetic field. Here the RF and the magnetic data may be combined by any suitable function into a compound interference measure. The function may comprise models that estimate the level of image artefacts for any planned or clinically suitable sequences for the current patient that will be caused by the interference. All input data collected over time at a certain location may be weighted based on how often and how strongly an interference was measured at a certain location in the past. It may also involve a weighting factor depending on time elapsed since measurement that emphasizes recent measurements over ones further in the past. The mapping unit can be part of the processor unit 5, for example.

In an embodiment of the invention a measurement of the actual noise at the moment of scanning is carried out in order to augment the data of the map, as explained above. Even awareness training for changing condition could be derived from the difference analysis and results could be displayed to the user - especially in dynamically changing environments.

In a further embodiment of the invention the RF noise and/or magnetic field measurements can also be done by handheld or wearable sensor devices 3, 4 which are suitable to be carried by staff or by autonomously self-driving vehicles that e.g., patrol the building, for example at night-time for the purpose of mapping. These devices 3, 4 send their data to the mapping unit of the main system, e.g., wirelessly using the hospital wireless network, by a dedicated network or by a simple direct cable connection to the MR receiver especially in case of handheld "sniffer coils". The devices 3,4 can identify operation locations which are historically identified as being unsuitable and should probably be avoided if possible. There is no guarantee that a new noise or field source has entered the proximity of a historically low noise area. As such in all preferred embodiments a measurement of the actual noise at the moment of scanning should always be carried out as explained above. The handheld or wearable sensor devices 3,4 can in this context be used to precisely identify noise sources in the vicinity of the portable MRI system 1.

In another embodiment of the invention the system comprises an artefact prediction unit configured to estimate the level of image artefacts in an MR imaging process that will be caused by estimated interferences. As input RF noise and external magnetic field at current location and at locations of external receivers, previously mapped data of that kind, current location itself, set of standard or planned sequences can be foreseen. The artefact prediction unit can also be part of the processor unit 5, for example. As output, an artefact score and proposals for MR imaging sequences and protocol parameters can be provided.

The results from the measurements can be used especially for live guidance. As inputs current locally measured interference and interference maps from data collected over time are used. The output can be reproduced e.g., on a user interface or output unit 16 with visual or audial or tactile or any other easily noticeable indication to the staff to choose a good imaging position based on the cleanliness of the current local and previously mapped environment. This may include a direct indication of the compound interference strength derived from current local RF noise strength and external magnetic field strength. An indication of the location of (strong RF) emitters e.g., as determined from directional RF antennas, and advice to move system in the opposite direction and/or provide information to assist the user to decide if moving the emitters is a better alternative, or a combination thereof. Further, a color map of cleanliness of the local environment based on data from the interference map can be provided. Arrows can be e.g., used to indicate a direction to go based on the spatial gradient of map data. Additional arrows can be used to indicate in which direction to turn the opening/bore of the portable MRI system for an optimized position and/or orientation. In addition concrete proposals for neighbored currently or probably "clean" imaging locations either on the map or in writing or speech output may be provided. Also, an overall "traffic light" may be provided, which indicates the predicted artifact level (image quality) of the planned scans at the current position/ direction. If the MR system itself is not moving at the moment, but still detects an increase (or decrease) in the local interference, then this is most likely due to some switching on (off) or some approach (removal) of a strong source of disturbance in the local environment. An alarm is issued in such cases so that the user can identify the emitting device. Alarms are logged so that identification can also be done retrospectively. Also, for example, dynamic interference visualization to show areas where situation changes depending on time or other conditions can be displayed on an output unit.

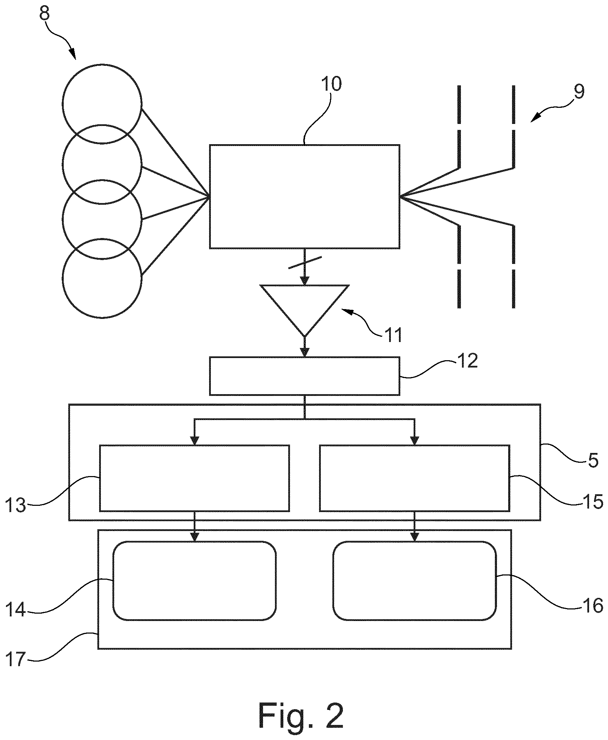

Fig. 2 schematically depicts an RF signal path of a portable MRI system 1 according to another embodiment of the invention. The MR-RF coil 8 of the MRI system 1 is a very sensitive receive antenna. Therefore, according to an embodiment of the invention it is proposed to configure the MR-RF coil 8 to be used as RF noise sensor 3 e.g., during transport of the system 1. This has the advantage that it detects any RF noise with the same spatial- and frequency-dependent receive characteristics that is also relevant for MR imaging. In addition, at least one of the at least one RF noise sensors is a directional RF antenna 9. Directional antennas 9 may be used for RF noise measurements, for example, to determine the location of strong RF emitters. These antennas 9 may also be coupled to the receive chain of the portable MRI system 1. In Fig. 2 it is shown that MR receive hardware for MRI and RF noise detection is used via the MR-RF receive coils and additional via directional antennas.

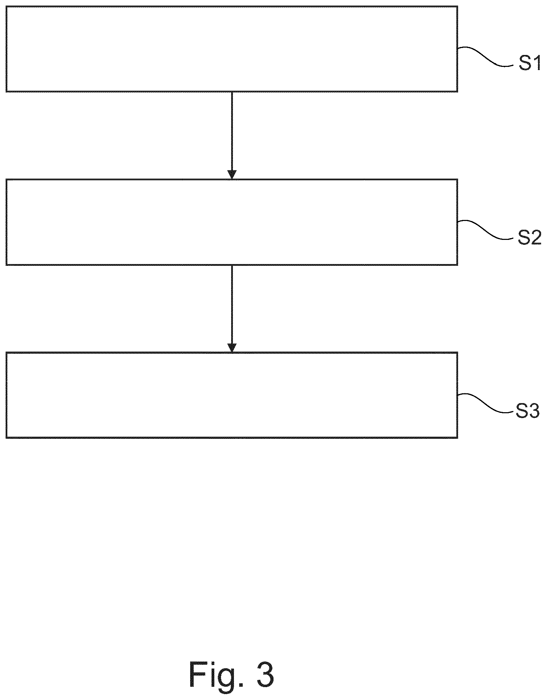

Fig. 3 depicts a flowchart of a computer-implemented method for determining an optimized position and/or orientation of a portable MRI system in a medical environment according to an embodiment of the invention. The medical environment 2 is influenced by RF noise and/or external magnetic field. Therefore, first, in step S1, RF noise is measured in the medical environment by at least one RF noise sensor and sensor data is provided, and/or the external magnetic field in the medical environment is measured by at least one external magnetic field sensor and also sensor data is provided. In step S2 the sensor data is evaluated, and a spatial distribution of the measured RF noise and the measured external magnetic field is created. In step S3 a position and/or orientation of the portable MRI system for an MR imaging process based on the spatial distribution of the measured RF noise and/or the measured external magnetic field is determined.

In an embodiment of the invention the method may comprise a further step of measuring RF noise and/or external magnetic field by sensors 3, 4 distributed in the medical environment 2 and/or measuring RF noise by an MR-RF coil 8 of the portable MRI system 1 and/or measuring RF noise by a directional RF antenna 9 and/or measuring external magnetic field by a Bo-coil of the portable MRI system 1.

In another embodiment of the invention the method may comprise a further step of creating an interference map with known and estimated interference strength based on the measured RF noise and external magnetic field. Also, for example, dynamic interference visualization to show areas where situation changes depending on time or other conditions can be displayed on an output unit. Potentially, layout data of the building can be used as input data for producing a map of the medical environment. The output is an "interference map" with known and estimated interference strength. Here the RF and the magnetic data may be combined by any suitable function into a compound interference measure.

In another embodiment a level of image artefacts in an MR imaging process caused by the estimated and known interferences is estimated.

Based on the evaluation of the measurement results the method may comprise the additional step of providing live guidance based on the sensor data to a portable MRI system operator to position and/or orient the portable MRI system 1. As inputs current locally measured interference and interference maps from data collected over time can be used. The output can be reproduced e.g., on a user interface or output unit 16 with visual or audial or tactile or any other easily noticeable indication to the staff to choose a good imaging position based on the cleanliness of the current local and previously mapped environment. This may include a direct indication of the compound interference strength derived from current local RF noise strength and external magnetic field strength. An indication of the location of (strong RF) emitters e.g., as determined from directional RF antennas, and advice to move system in the opposite direction and/or provide information to assist the user to decide if moving the emitters is a better alternative, or a combination thereof.

In another exemplary embodiment of the present invention, a computer program or a computer program element is provided, which when being executed by at least one processing unit, is adapted to cause the processing unit to perform the steps of the method of the preceding section.

According to a further exemplary embodiment of the present invention, a computer readable medium, such as a CD-ROM, is presented wherein the computer readable medium has a computer program element stored on it which computer program element is described by the preceding section.

A computer program may be stored/distributed on a suitable medium, such as an optical storage medium or a solid-state medium supplied together with or as part of other hardware, but may also be distributed in other forms, such as via the Internet or other wired or wireless telecommunication systems.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| portable magnetic resonance imaging (MRI) system | 1 |
| medical environment | 2 |
| RF noise sensor | 3 |
| magnetic field sensor | 4 |
| processor unit | 5 |
| memory | 6 |
| processor | 7 |
| MR-RF coil | 8 |
| RF directional antenna | 9 |
| switch | 10 |
| preamplifier | 11 |
| ADC | 12 |
| MRI reconstruction unit | 13 |
| MRI output unit | 14 |
| guidance reconstruction unit | 15 |
| guidance output unit | 16 |
| output unit | 17 |

## Claims

1. A system for determining an optimized position and/or orientation of a portable magnetic resonance imaging (MRI) system (1) for an MR imaging process in a medical environment (2) influenced by RF noise and/or an external magnetic field, the system comprising:
- at least one RF noise sensor (3), wherein the RF noise sensor (3) is configured for measuring RF noise in the medical environment (2) and to provide sensor data,
- at least one magnetic field sensor (4), wherein the magnetic field sensor (4) is configured to measure the external magnetic field in the medical environment (2) and to provide sensor data,
- a processor unit (5), wherein the sensors (3, 4) are connected to the processor unit (5), the processor unit (5) comprising:
- at least one memory (6) for storing instructions,
- at least one processor (7) configured to execute the instructions to cause the following to be performed:
- measuring RF noise and/or the external magnetic field in the medical environment (2) by means of corresponding sensors (3, 4),
- evaluating the sensor data and creating spatial distributions of the measured RF noise and/or the measured external magnetic field in the medical environment (2),
- determining a position and/or orientation of the portable MRI system (1) in the medical environment (2) for an MR imaging process based on the spatial distributions of the measured RF noise and/or the measured external magnetic field.

2. The system according to claim 1, wherein the at least one RF noise sensor (3) and/or the at least one magnetic field sensor (4) are distributed in the medical environment (2).

3. The system according to any preceding claim, wherein the at least one RF noise sensor (3) and/or the at least one magnetic field sensor are portable sensor devices, wherein the portable sensor devices are connected to the portable MRI system wirelessly or by cable.

4. The system according to any preceding claim, wherein the at least one RF noise sensor (3) and/or the at least one magnetic field sensor are handheld or wearable sensor devices which are suitable to be carried by staff and/or suitable to be carried by autonomously self-driving vehicles.

5. The system according to any preceding claim, wherein an MR-RF coil (8) of the portable MRI system is configured to be used as RF noise sensor (3) to measure RF noise.

6. The system according to any preceding claim, wherein the at least one of the at least one RF noise sensors (3) is a directional RF antenna (9) for RF noise measurements.

7. The system according to claim 6, wherein the system is configured such that the directional RF antenna (9) is read out by the MR receive chain of the portable MRI system (1).

8. The system according to any preceding claim, wherein a Bo-coil of the portable MRI system (1) is configured to be used as magnetic field sensor (4) to measure the external magnetic field.

9. The system according to any preceding claim, the system comprising at least one sensor for measuring motion and/or position of the portable MRI system.

10. The system according to any preceding claim, the system comprising a mapping unit, wherein the mapping unit is configured to create an interference map with known and estimated interference strength based on the measured RF noise and external magnetic field.

11. The system according to claim 10, the system comprising an MR artefact prediction unit, wherein the MR artefact prediction unit is configured to estimate a level of image artefacts in an MR imaging process that will be caused by the estimated interferences.

12. A computer-implemented method for determining an optimized position and/or orientation of a portable magnetic resonance imaging (MRI) system (1) for an MR imaging process in a medical environment (2) influenced by RF noise and/or an external magnetic field, the method comprising the following steps:
- measuring RF noise in the medical environment (2) by at least one RF noise sensor (3) and providing sensor data and/or measuring the external magnetic field in the medical environment (2) by at least one magnetic field sensor (4) and providing sensor data,
- evaluating the sensor data and creating a spatial distribution of the measured RF noise and the measured external magnetic field,
- determining a position and/or orientation of the portable MRI system (1) for an MR imaging process based on the spatial distribution of the measured RF noise and/or the measured external magnetic field.

13. The method according to claim 12, wherein the step of measuring RF noise and/or external magnetic field by means of corresponding sensors (3, 4) in the medical environment (2) comprises the step of:
- measuring RF noise and/or external magnetic field by sensors (3, 4) distributed in the medical environment (2) and/or measuring RF noise by an MR-RF coil (8) of the portable MRI system (1) and/or measuring RF noise by a directional RF antenna (9) and/or measuring external magnetic field by a Bo-coil of the portable MRI system (1).

14. The method according to any one of claims 12 to 13, the method comprising the following additional step:
- creating an interference map with known and estimated interference strength based on the measured RF noise and external magnetic field.

15. The method according to claim 14, the method comprising the following additional step:
- estimating a level of image artefacts in an MR imaging process caused by the estimated and known interferences.

16. The method according to any one of claims 12 to 15, the method comprising the following additional step:
- providing live guidance based on the sensor data to a portable MRI system operator to position and/or orient the portable MRI system (1).
